# NEUE EUROPÄISCHE PATENTSCHRIFT

(11) **EP 2 366 146 B2**
(45) Veröffentlichungstag und Bekanntmachung des Hinweises auf die Entscheidung über den Einspruch: **12.10.2016**
(45) Hinweis auf die Patenterteilung: 05.09.2012
(21) Anmeldenummer: 09810881.4
(22) Anmeldetag: 23.12.2009
(51) Int. Cl.: G06F 9/455, G06F 17/50, G06F 11/34

(54) **VERFAHREN UND DATENVERARBEITUNGSSYSTEM ZUR SIMULATION EINES EINGEBETTETEN SYSTEMS**
METHOD AND DATA PROCESSING SYSTEM FOR SIMULATING AN EMBEDDED SYSTEM
PROCÉDÉ ET SYSTÈME DE TRAITEMENT DE DONNÉES POUR SIMULER UN SYSTÈME INTÉGRÉ

(43) Veröffentlichungstag der Anmeldung: 21.09.2011
(73) Patentinhaber: Inchron GmbH, 14482 Potsdam (DE)
(72) Erfinder: DÖRFEL Matthias, 82275 Emmering (DE); MÜNZENBERGER, Ralf, 91052 Erlangen (DE)
(74) Vertreter: Vossius & Partner Patentanwälte Rechtsanwälte mbB
(86) Internationale Anmeldenummer: PCT/EP2009/067871
(87) Internationale Veröffentlichungsnummer: WO 2011/076278

(56) Entgegenhaltungen:
- WO-A1-01/35223
- CN-A- 101 013 384
- US-A1- 2008 228 461
- BAMMI J R ET AL: "SOFTWARE PERFORMANCE ESTIMATION STRATEGIES IN A SYSTEM-LEVEL DESIGNTOOL" PROCEEDINGS OF THE 8TH. INTERNATIONAL WORKSHOP ON HARDWARE/SOFTWARE CODESIGN. CODES 2000. SAN DIEGO, CA, MAY 3 - 5, 2000; [PROCEEDINGS OF THE INTERNATIONAL WORKSHOP ON HARDWARE/SOFTWARE CODESIGN], NEW YORK, NY : ACM, US LNKD- DOI:10.1109/HSC.2000.843, 3. Mai 2000 (2000-05-03), Seiten 82-86, XP000966204 ISBN: 978-1-58113-214-4 in der Anmeldung erwähnt
- MUELLER, WOLFGANG ET AL.: '"The Simulation Semantics of SystemC" Design, Automation & Test in Europe, 2001'
- ROSENTIEL, WOLFGANG ET AL.: '"Timing Simulation of interconnected AUTOSAR Software-Components" Design, Automation & Test in Europe, 2007'
- MUELLER, WOLFGANG ET AL.: '"Hardware-dependent Software" Springer, 2009 ISBN: 978 1 4020 9436 1' Seiten 263 - 295

## Beschreibung

Die Erfindung betrifft ein computergestütztes oder computer-implementiertes Verfahren und Datenverarbeitungssystem zur Simulation eines eingebetteten Systems, insbesondere zur computergestützten Simulation eines eingebetteten Systems.

Unter einem eingebetteten System versteht man einen Computer, der in einen technischen Kontext eingebunden bzw. eingebettet ist. Dabei hat der Computer die Aufgabe, das System insbesondere zu steuern, zu regeln oder zu überwachen. Oft werden eingebettete Systeme im Hinblick auf eine zu lösende technische Aufgabe besonders angepasst. Dazu wird häufig eine gemischte Hardware-/Softwareimplementierung gewählt, deren Teile über einen Datenbus zum Datenaustausch miteinander verbunden sind. Die Hardware-/Softwareimplementierung muss üblicherweise Echtzeitanforderungen genügen. Aus Kostengründen ist es von erheblichem Vorteil, die Echtzeitfähigkeit einer geplanten Hardware-/Softwareimplementierung vor deren Realisierung zu simulieren. Eine solche Simulation eines eingebetteten Systems bzw. eines Zielsystems findet üblicherweise auf einem so genannten Hostcomputer statt.

Eine gemischte Hardware-/Softwareimplementierung eines eingebetteten Systems besteht aus einem oder mehreren Mikroprozessoren, die ein Anwendungsprogramm abarbeiten, und einer oder mehreren Hardwareeinheiten, die eine festkodierte Aufgabe nebenläufig zu den Mikroprozessoren und den anderen Hardwareeinheiten erfüllen. Die Realisierung des Anwendungsprogramms erfolgt meist auf der Basis nebenläufiger Prozesse und verwendet meist Interruptroutinen, die von der Umgebung oder von den anderen Mikroprozessoren oder Hardwareeinheiten ausgelöst werden. Die Reihenfolge der Abarbeitung der nebenläufigen Prozesse auf einem Mikroprozessor wird durch einen zum Betriebssystem gehörenden Scheduler festgelegt. Dieser wählt nach vorgegebenen Kriterien (Priorität, Zeitschranke, etc.) aus der Menge der rechenbereiten Prozesse den nächsten auszuführenden Prozess aus. Immer häufiger kommen dabei auch hierarchische Schedulingsysteme zur Verwendung, beispielsweise um im Zeitscheibenverfahren mehrere Anwendungsprogramme voneinander zu trennen.

Die einfachste Möglichkeit zur Simulation eines eingebetteten Systems ist eine Softwaresimulation, bei welcher der Quellcode in einen für den Betrieb des Prozessors des Hostcomputers geeigneten Maschinencode übersetzt und dann auf diesem ausgeführt wird. Dabei können noch Umgebungsparameter, z. B. die Speicherkonfiguration, eine Ein-/Ausgabe mittels Lesen bzw. Schreiben auf virtuellen Ports und dergleichen, des Zielsystems berücksichtigt werden.

In vielen Fällen ist es allerdings erforderlich, auch die Hardware des Zielsystems auf dem Hostrechner zu simulieren. Dazu verwendet man heute üblicherweise sogenannte Instruction Set Simulatoren (ISS), mit denen Hardwarekomponenten, beispielsweise Prozessoren, Controller und dergleichen, simuliert werden können. Zu diesem Zweck arbeiten derartige ISS den für die jeweilige Hardwarekomponente erzeugten Maschinencode auf dem Hostrechner ab. Damit lässt sich die Funktionalität einer für ein eingebettetes System vorgesehenen Software prüfen.

Zur Simulation werden derzeit vorwiegend interpretativ arbeitende ISS eingesetzt. Derartige ISS arbeiten wegen der erforderlichen Übersetzungszeiten allerdings relativ langsam und sind infolgedessen für eine exakte Simulation der Echtzeitfähigkeit eines eingebetteten Systems nicht geeignet. Um diesem Nachteil entgegenzuwirken, werden nach dem Stand der Technik auch so genannte static-compiled ISS eingesetzt, deren Simulationsgeschwindigkeit deutlich höher ist als die interpretativ arbeitender ISS. Allerdings sind static-compiled ISS im Hinblick auf die Simulation dynamischer Vorgänge nicht besonders flexibel. Das ist der Genauigkeit bei der Ermittlung der Echtzeitfähigkeit eines eingebetteten Systems abträglich.

Moo-Kyong Chung, Chong-Min Kyung, "Improvement of Compiled Instruction Set Simulator by Increasing Flexibility and Reducing Compile Time", Proceedings of the 15th IEEE International Workshop on Rapid System Prototyping (RSP'04), 1074-6005/2004 IEEE offenbart einen Ansatz, bei dem bei der Simulation anstelle eines binären Formats ein Objektformat eingegeben wird. Durch den Einsatz von dynamischen Sprunghandlern kann eine Verringerung der Übersetzungszeiten und gleichzeitig eine Verbesserung der Flexibilität erreicht werden.

Die WO 01/35223 A1 beschreibt eine Simulation eines Anwendungsprogramms auf einer simulierten Hardware. Dabei wird das Anwendungsprogramm zunächst in Programmsegmente zerlegt und mit Tags versehen. Bei der Simulation auf dem Hostcomputer kann unter Verwendung der Tags die Ausführungszeit des jeweiligen Programmsegments abgeschätzt werden. Durch eine Addition der Ausführungszeiten kann auf die Gesamtausführungszeit des Anwendungsprogramms geschlossen werden.

Jianwen Zhu, Daniel D. Gajski, "An Ultra-Fast Instruction Set Simulator", IEEE Transactions on very large scale Integration (VLSI) Systems, Vol. 10, Nr. 3, Juni 2002, 1063-8210/2002 IEEE offenbart ein Verfahren zur Beschleunigung der Simulation. Auf der Basis einer statischübersetzten Instruction Set Architektur (ISA) wird anstelle der Generierung eines herkömmlichen C-Codes eine spezielle low-level Codegenerierungsschnittstelle definiert. Für den damit erzeugten Zwischencode wird eine RISC-Struktur vorgeschlagen, die über einen vordefinierten, minimalen Befehlssatz, aber eine unbegrenzte Anzahl virtueller Register verfügt. Im Vergleich zu dynamic-compiled ISSs ermöglicht die Verwendung des vorgeschlagenen Zwischencodes eine Portabilität auf andere Hostcomputer. Außerdem ist eine direkte Manipulation der Ressourcen des Hostcomputers möglich.

Jwahar R. Bammi, et al., "Software Performance Estimation Strategies in a System-Level Design Tool", CODES 2000, San Diego, CA USA, ACM 2000 1-58113-268-9/00/05 offenbart zwei Verfahren zur Abschätzung der Ausführungszeiten bei einem eingebetteten System. Bei beiden Verfahren wird der Programmcode mit Informationen über die Ausführungszeit und anderen zeitrelevanten Informationen versehen.

Die US 6,230,114 B1 offenbart ein Co-Simulations-Design-System. Dabei ahmen modellbasierte Prozesssimulatoren, welche über Schnittstellen miteinander verbunden sind, auf einem Hostsystem die Kommunikation zwischen beiden Simulatoren nach.

Sämtliche nach dem Stand der Technik bekannten Verfahren haben den Nachteil, dass damit eine Simulation komplexer Systeme, welche insbesondere mehrere kooperierende Prozessoren umfassen, nicht möglich ist.

Aufgabe der vorliegenden Erfindung ist es, die Nachteile nach dem Stand der Technik zu beseitigen. Es soll insbesondere ein Verfahren zur Simulation eines eingebetteten Systems angegeben werden, mit dem insbesondere die Funktionalität und/oder das Zeitverhalten eines komplexen eingebetteten Systems mit verbesserter Genauigkeit simulierbar ist. Nach einem weiteren Ziel der Erfindung soll das Verfahren eine möglichst einfache Abbildbarkeit des Zielsystems auf dem Hostcomputer ermöglichen.

Nach einem weiteren Ziel der Erfindung soll die effiziente Simulation eines komplexen eingebetteten Systems mit hierarchischen Schedulingverfahren möglich sein.

Diese Aufgabe wird durch die Merkmale de unabhängigen Ansprüche 1, 10, 11 und 12 gelöst. Zweckmäßige Ausgestaltungen der Erfindung ergeben sich aus den Merkmalen der abhängigen Ansprüche..

Nach Maßgabe der Erfindung wird ein computergestütztes Verfahren zur Simulation eines eingebetteten Systems vorgeschlagen, bei dem mehrere, jeweils aus einer mit einer Software versehenen Hardware gebildete Komponenten über ein Datenaustauschnetzwerk miteinander zum Datenaustausch verbunden sind,
wobei in einem Simulationsprogramm jede Komponente als eine eine Menge von Prozessen verwaltende Verarbeitungseinheit simuliert wird,
wobei mit dem Simulationsprogramm dynamisch jeder der Verarbeitungseinheiten eine Startzeit zugeordnet wird,
wobei die Verarbeitungseinheiten dynamisch entsprechend ihrer Startzeiten aufeinanderfolgend sortiert werden,
wobei mittels eines Schedulers jeweils die Verarbeitungseinheit mit der nächsten Ausführungszeit ausgewählt wird,
wobei infolge der Auswahl einer Verarbeitungseinheit der ihr zugeordnete aktive Prozess durch Abarbeitung eines aus einem dazu korrespondierenden Basisblockgraphen abgeleiteten Programmcode simuliert und als Ergebnis der Simulation die für die Abarbeitung benötigte Zeit und/oder eine Information über die damit bewirkte Funktion ermittelt wird.

Mit dem vorgeschlagenen Verfahren ist es möglich, eine exakte Voraussage über die Echtzeitfähigkeit eines eingebetteten Systems, insbesondere eines komplexen eingebetteten Systems, zu machen.

Im Sinne der vorliegenden Erfindung wird unter einer "Verarbeitungseinheit" ein Programmabschnitt verstanden, mit dem sowohl die Hardware als auch die Software der jeweiligen Komponenten abgebildet wird. Jede Verarbeitungseinheit ist von einer allgemeinen Verarbeitungseinheit-Programmstruktur abgeleitet. Eine solche Verarbeitungseinheit-Programmstruktur enthält beispielsweise Tabellen zur Speicherung von Umgebungsparametern und dergleichen.

Unter dem Begriff "Startzeit" wird ein Zeitpunkt verstanden, an dem die Verarbeitungseinheit durch den ersten Scheduler ausgewählt und aktiviert wird. Infolgedessen wird der auf der Verarbeitungseinheit aktive Prozess abgearbeitet. Die Startzeiten werden den Verarbeitungseinheiten dynamisch mittels im Simulationsprogramm vorgegebenen Algorithmen zugewiesen. Startzeiten können während des Ablaufs des Simulationsprogramms ersetzt werden, so dass die jeweilige Verarbeitungseinheit in der Abfolge der Verarbeitungseinheiten eine andere Position einnimmt.

Im Sinne der vorliegenden Erfindung wird unter einem "Prozess" beispielsweise eine Task, ein Thread, ein Betriebssystemprozess, eine Interruptserviceroutine (ISR) verstanden, welche im Simulationsprogramm auf einem dazu simulierten Prozessor simuliert wird.

Unter einem "Basisblock" (BB) wird ein Teil einer Befehlsabfolge eines Programms verstanden, in dem eine maximale Sequenz aufeinanderfolgender Instruktionen zusammengefasst ist. Dabei ist eine Sequenz so definiert, dass der Ausführung der ersten Instruktion die unbedingte Ausführung aller anderen Instruktionen der Sequenz folgen muss.

Zur Herstellung des Simulationsprogramms werden die Prozesse in Form eines Basisblockgraphen dargestellt. Dabei kann jeder Prozess einen oder mehrere Basisblöcke umfassen.

Im Sinne der vorliegenden Erfindung wird unter dem Begriff "Simulationsprogramm" ein Computerprogramm verstanden, welches auf einem vom zu simulierenden eingebetteten System verschiedenen "Hostcomputer" ausgeführt wird.

Nach einer vorteilhaften Ausgestaltung ist vorgesehen, dass jeder Verarbeitungseinheit ein Uhrensimulationsprogramm zugeordnet ist und die für die Abarbeitung eines Prozesses benötige lokale Zeit unter Verwendung des Uhrensimulationsprogramms ermittelt wird. Durch die Einbindung des vorgeschlagenen Uhrensimulationsprogramms ist eine besonders realitätsnahe Simulation möglich. Jede Verarbeitungseinheit wird in einer ihr eigenen zeitlichen Umgebung simuliert. Geeignete Uhrensimulationsprogramme sind nach dem Stand der Technik beispielsweise aus der WO 02/21261 bekannt. Die Abarbeitung eines Prozesses unter Verwendung der für die jeweilige Verarbeitungseinheit simulierten Uhr liefert eine "lokale Zeit" bzw. einen Zeitabschnitt. Nach einer vorteilhaften Ausgestaltung ist vorgesehen, dass die lokalen Zeiten unter Verwendung der Systemzeit in die Startzeiten umgerechnet werden. Die so ermittelten Startzeiten berücksichtigen also die lokale Zeitumgebung der Verarbeitungseinheiten. Das erhöht weiter die Präzision des vorgeschlagenen Verfahrens, insbesondere die Präzision der Ermittlung der Echtzeitfähigkeit eines mit dem vorgeschlagenen Verfahren simulierten eingebetteten Systems.

In einer weiteren vorteilhaften Ausgestaltung wird die Struktur der hierarchischen Scheduler des eingebetteten Systems im Simulationsprogramm durch eine äquivalente Hierarchie von Scheduler-Programmstrukturen abgebildet, die die zugeordneten Programmstrukturen der Prozesse des eingebetteten Systems verwalten und in der gleichen Weise Scheduling-Entscheidungen treffen wie die Scheduler im eingebetteten System. Vorteilhafterweise treffen die Scheduler nicht bei jedem Simulationszyklus eine neue Entscheidung auf der Basis der Prozesslisten der zugeordneten Verarbeitungseinheit, sondern nur bei Zustandswechseln der von den Schedulern verwalteten Prozesse und/oder an den durch ein TDMA-Scheduling definierten Zeitpunkten.

Zweckmäßigerweise wird jeder Prozess durch zumindest einen Basisblock im Basisblockgraphen beschrieben. Dabei wird der Basisblock zweckmäßigerweise mit einer Information versehen, die es ermöglicht, die für die Abarbeitung des Basisblocks erforderliche Ausführungszeit und/oder die durch die Abarbeitung des Basisblocks erzeugte Funktion zu ermitteln. Zur Herstellung des Simulationsprogramms wird nachfolgend der die Basisblöcke enthaltende Basisblockgraph mittels eines Compilers in den Programmcode übersetzt. D. h. der Programmcode enthält also die zuvor eingefügte Informationen. Damit kann präzise der Verlauf der Simulation für jeden der Prozesse nachvollzogen werden. So kann schnell und einfach erkannt werden, ob und ggf. an welcher Stelle ein zu simulierendes Ausführungsprogramm optimiert werden kann. Nach der Abarbeitung eines zu einem Basisblock korrespondierenden Programmcodeabschnitts in Abhängigkeit vorgegebener Parameter wird geprüft, ob mittels des Schedulers die nächste Verarbeitungseinheit aus der Verarbeitungseinheitenliste auszuwählen ist und/oder ob der aktive Prozess auf der ausgewählten Verarbeitungseinheit fortzusetzen ist.

Nach einer vorteilhaften Ausgestaltung weist das Simulationsprogramm einen die Verarbeitungseinheiten umfassenden ersten Programmabschnitt und einen die Ausführungszeiten und/oder die Funktion ermittelnden zweiten Programmabschnitt auf. Der erste Programmabschnitt enthält die Informationen über das zu simulierende eingebettete System. Er ist für jedes zu simulierende eingebettete System neu zu erstellen. Der zweite Programmabschnitt dient der Ausführung und Steuerung des Simulationsprogramms, insbesondere aber der Ermittlung der Ausführungszeiten und/oder Funktionen. Er muss nicht im Hinblick auf das jeweils zu simulierende eingebettete System angepasst werden.

Nach einer besonders einfachen Verfahrensvariante wird das Simulationsprogramm auf einem Hostcomputer durchgeführt, dessen Prozessor identisch oder ähnlich mit einem weiteren Prozessor des eingebetteten Systems ist. In diesem Fall lässt sich ein dem Simulationsprogramm zu Grunde liegendes Simulationsmodell einfach durch Übersetzung des zu simulierenden Anwendungsprogramms auf den Hostrechner herstellen. Das erfindungsgemäße Verfahren kann selbstverständlich auch auf Hostrechnern durchgeführt werden, deren Prozessor verschieden von einem oder mehreren Prozessoren des eingebetteten Systems ist.

Bei dem vorgeschlagenen Verfahren werden die Komponenten eines eingebetteten Systems als Verarbeitungseinheiten abgebildet. Damit kann das vorgeschlagene Verfahren erheblich schneller ausgerührt werden als die bisher bekannten Verfahren, bei denen jede Komponente durch mehrere Simulationsprogrammabschnitte simuliert wird. Bei den Simulationsprogrammabschnitten handelt es sich um ein ISS sowie einen Simulationsprogrammabschnitt, der einen Controller simuliert. Zwischen den Simulationsprogrammabschnitten findet ein reziproker Datenaustausch statt, der die Ausführungsgeschwindigkeit herabsetzt. Bei den nach der vorliegenden Erfindung vorgeschlagenen Verarbeitungseinheiten findet ein solcher reziproker Datenaustausch nicht statt.

Ferner wird ein Datenverarbeitungssystem vorgeschlagen zur Simulation eines eingebetteten Systems, bei dem mehrere, jeweils aus einer mit einer Software versehenen Hardware gebildete Komponenten über ein Datenaustauschnetzwerk miteinander zum Datenaustausch verbunden sind, mit einem Simulationsprogramm, in dem jede Komponente als eine eine Menge von Prozessen verwaltende Verarbeitungseinheit simuliert wird, wobei mit dem Simulationsprogramm dynamisch jeder der Verarbeitungseinheiten eine Startzeit zugeordnet wird, einer Sortiereinrichtung, die die Verarbeitungseinheiten dynamisch entsprechend ihrer Startzeiten aufeinanderfolgend sortiert, einem Scheduler zum Auswählen der Verarbeitungseinheit mit der nächsten Startzeit, wobei das Datenverarbeitungssystem infolge der Auswahl einer Verarbeitungseinheit den ihr zugeordneten aktive Prozess durch Abarbeitung eines aus einem dazu korrespondierenden Basisblockgraphen abgeleiteten Programmcode simuliert und als Ergebnis der Simulation die für die Abarbeitung benötigte Zeit und/oder eine Information über die damit bewirkte Funktion ermittelt wird.

Nachfolgend wird ein Ausführungsbeispiel der Erfindung anhand der Zeichnungen näher erläutert. Es zeigen:
- Fig. 1: einen Überblick über die wesentlichen Herstellungsschritte eines erfindungsgemä-ßen Simulationsprogramms,
- Fig. 2: einen Überblick über die Architektur eines erfindungsgemäßen Simulationsprogramms,
- Fig. 3: den Funktionsablauf des erfindungsgemäßen Verfahrens; und
- Fig. 4: den Ablauf bei der simulierten Aktivierung eines Prozesses durch den gerade laufenden Prozess.

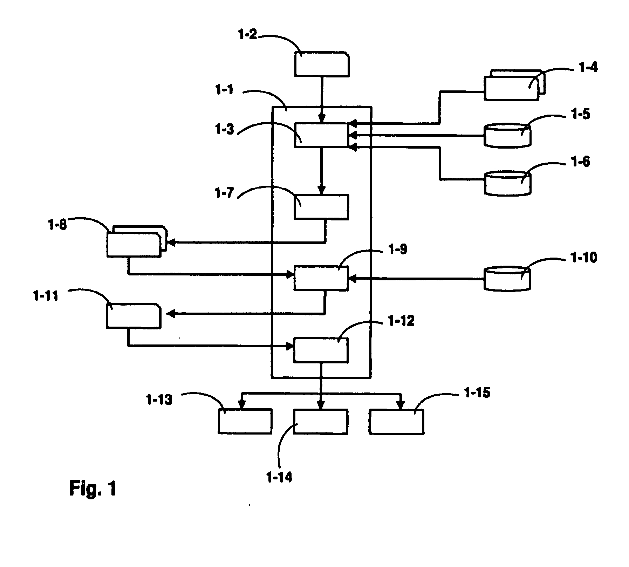

Fig. 1 zeigt die wesentlichen Schritte zur Herstellung eines Simulationsprogramms eines Simulationsprogramms.

Zur Herstellung eines Simulationsprogramms zur Simulation eines eingebetteten Systems auf einem Hostsystem 1-1 wird beispielsweise aus dem Source-Listing eines vorgegebenen Anwendungsprogramms 1-4, den Parameterdateien 1-5 der Verarbeitungseinheiten, den Verhaltensmodellen weiterer, im eingebetteten System enthaltener Hardwarekomponenten 1-6 sowie einer das zu simulierende eingebettete System beschreibenden Projektdatei 1-2 in einer Voranalyse 1-3 ein erster Simulationsprogrammabschnitt bzw. ein Simulationsmodell 1-8 in Form eines Objektcodes für das Hostsystem 1-1 hergestellt (Compiler 1-7). Das Simulationsmodell 1-8 wird schließlich durch den Binder 1-9 mit einem festen Simulationsprogrammabschnitt 1-10 zu einem ausführbaren Programm 1-11 gebunden und auf dem Hostsystem 1-1 ausgeführt. Das Ergebnis der ablaufenden Simulation 1-12 kann ein Report 1-13, eine Simulationsspur 1-14 oder graphische Diagramme 1-15 zur Darstellung des Systemverhaltens sein. Das Simulationsmodell 1-8 umfasst eine Menge von Informationen, Beschreibungsblöcken und Konfigurationsdaten, die zweckmä-ßigerweise in der Voranalyse aus Listen oder Datenstrukturen von Objekten im Speicher des Hostsystems 1-1 aufgebaut werden. Dabei lassen sich die Eigenschaften und Fähigkeiten der Objekte als Attribute und Methoden der Objekte abbilden.

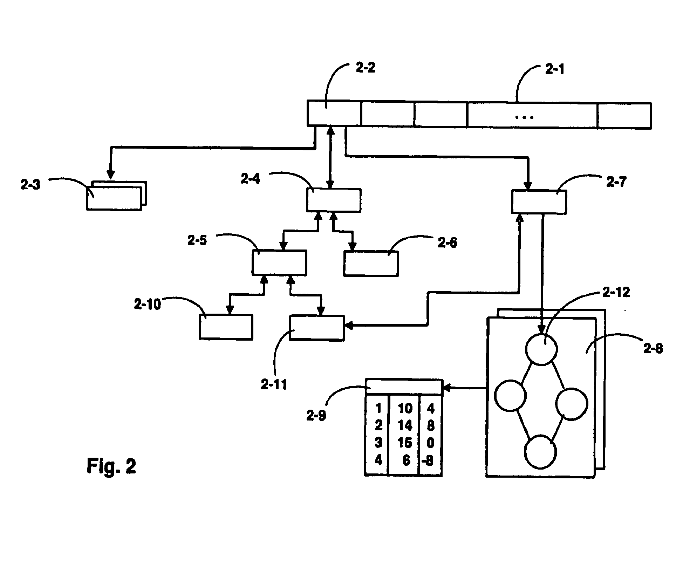

Wie aus Fig. 2 ersichtlich ist, umfasst das Simulationsprogramm insbesondere die folgenden Elemente:
Eine Verarbeitungseinheit-Liste 2-1 umfasst sämtliche Verarbeitungseinheiten 2-2 des eingebetteten Systems. Sie kann beispielsweise aus der Beschreibung des Zielsystems in einer Projektdatei oder den Parametern 2-3 der Verarbeitungseinheiten 2-2 sowie eventuell den Verhaltensmodellen aktiver Hardwarekomponenten aufgebaut werden. Es können weitere Prozesse aus den Verhaltensmodellen der Hardwarekomponenten abgeleitet und ergänzt werden. Für jede der Verarbeitungseinheiten 2-2 wird ein aktuelles Prozessereignis 2-7 bestimmt.

Zu jedem Prozess 2-6, 2-10, 2-11 oder einer Mehrzahl oder allen Prozessen einer Verarbeitungseinheit 2-2 existiert ein korrespondierender Basisblockgraph 2-8. Der Basisblockgraph 2-8 wird durch eine Analyse der Assemblercodeabfolge so gebildet, dass die Basisblöcke 2-12 als Knoten und die funktionalen Übergänge zwischen den Basisblöcken als Kanten dargestellt werden. Der Basisblockgraph 2-8 zerlegt einen Prozess in Basisblöcke. Der Zeitbedarf für die Abarbeitung eines Basisblocks 2-12 ist statisch aus den Knoten bestimmbar. Aus den Kanten des Basisblockgraphen 2-8 kann mittels des Simulationsprogramms das dynamische Verhalten eines Prozesses ermittelt werden.

Bei der Erstellung des Basisblockgraphen 2-8 wird eine Liste 2-9 mit den statischen Anteilen der jeweiligen Ausführungszeit eines Prozesses angelegt. Aus dem analysierten Assemblercode des Prozesses wird gleichzeitig ein funktional identischer, aber in Basisblökke 2-12 unterteilter Hostquellcode erstellt, der unter Verwendung eines Hostcompilers in einen Objektcode übersetzt und den funktionalen Teil des Simulationsprogramms bildet.

Die Eigenschaften 2-3 der Verarbeitungseinheiten enthalten Daten zur Konfiguration des Simulationsmodells entsprechend dem eingebetteten System. Die Daten beziehen sich auf die hierarchische Struktur der Scheduler 2-4 und 2-5, die Art des Scheduling bzw. die Auswahl des Scheduling-Verfahrens, beispielsweise "First Come, First Serve", "Prioritätsbasiert" oder "Round Robin" und dergleichen. Ferner können die Daten Informationen zur Nachbildung der Speicherstrukturierung und -verwaltung enthalten.

Nach einer bevorzugten Ausgestaltung kann das Simulationsmodell dadurch entstehen, dass das Anwendungsprogramm als Assemblercode für das eingebettete System mit einem kompilierten Instruction Set Simulator (ISS) des eingebetteten Systems ausgeführt wird. Dabei können Variationen des eingebetteten Systems in Form einer Auflistung von Umgebungsparametern im Simulationsmodell berücksichtigt werden. Das Simulationsmodell kann ferner durch eine Datei mit Ausführungszeiten für einzelne oder alle Teilabläufe der Hardware und des Anwendungsprogramms auf dieser Hardware ergänzt werden. Aus dieser Datei kann aus der Simulation das Zeitverhalten des eingebetteten Systems rekonstruiert und berechnet werden. Der ISS kann auch durch einen virtuellen ISS ersetzt werden, der auf technischen Informationen aus dem Datenblatt des eingebetteten Systems, aus dessen Hardware-Spezifikation oder dem VHDL-Code oder ähnlichen Unterlagen hergestellt wird. Das Anwendungsprogramm kann für das Simulationsmodell auf der Grundlage von Informationen aus dem Datenblatt des eingebetteten Systems, aus dessen Hardware-Spezifikation oder dem VHDL-Code oder ähnlichen Unterlagen manuell als Hostquellcode programmiert werden.

Nach einer weiteren Variante kann das Anwendungsprogramm auch auf mehreren eingebetteten Systemen ausgeführt werden. In diesem Fall kann das Simulationsmodell dadurch entstehen, dass mittels eines komplexen Vorverarbeitungsprogramms verschiedene Anwendungsprogrammmodule auf den dem jeweiligen eingebetteten System entsprechenden kompilierten ISS ausgeführt werden. Variationen der Zielsysteme sowie der sie verbindenden Kommunikationssysteme können durch eine Auflistung von Umgebungsparametern im Simulationsmodell berücksichtigt werden.

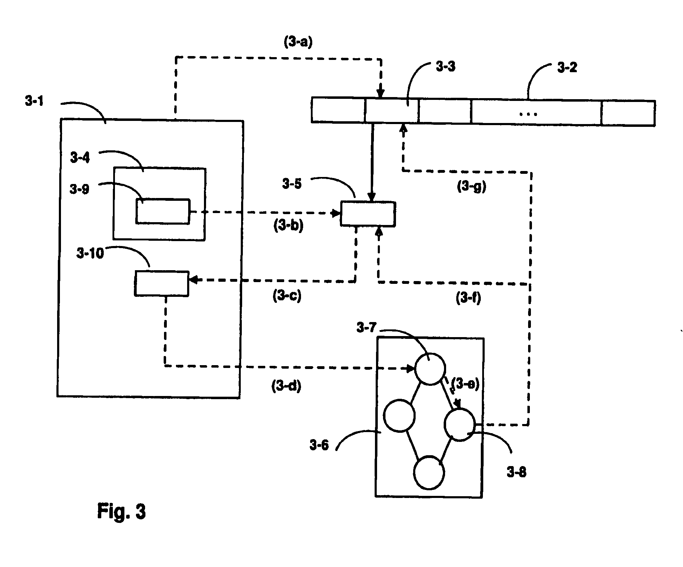

Fig. 3 zeigt Verfahrensschritte eines Simulationszyklus. Ein im Simulationskern 3-1 laufender Scheduler 3-4 wählt aus einer Liste 3-2 von nach ihren Startzeiten sortierten Verarbeitungseinheiten diejenige Verarbeitungseinheit 3-3 mit der nächsten Startzeit aus (Schritt 3-a). Anschlie-ßend wird der aktive Prozess der gewählten Verarbeitungseinheit abgearbeitet, der im Prozessereignis 3-5 referenziert wird (3-b)(3-c).

Zur Abarbeitung des aktiven Prozesses 3-10 wird ein Programmcodeabschnitt des dazu korrespondierenden Basisblocks 3-7 im Basisblockgraphen 3-6 abgearbeitet (3-d)(3-e). Nach der Abarbeitung eines Basisblocks wird der nächste Basisblock im Prozessereignis 3-5 aktualisiert (3-f). Anschließend wird geprüft, ob durch den dann geänderten Systemzustand und Zeitfortschritt ein erneuter Scheduling-Vorgang erforderlich ist. Ein erneuter Scheduling-Vorgang ist auf der Verarbeitungseinheit 3-3 nur dann erforderlich, wenn die Abarbeitung des Basisblockgraphen 3-6 den aktuell simulierten Prozess beendet oder deaktiviert hat oder einen anderen Prozess auf der gleichen oder einer anderen Verarbeitungseinheit 3-3 aktiviert oder deaktiviert hat. In diesem Fall wird die Startzeit der betroffenen Verarbeitungseinheit aktualisiert (3-g). Anschließend beginnt der Simulationszyklus erneut.

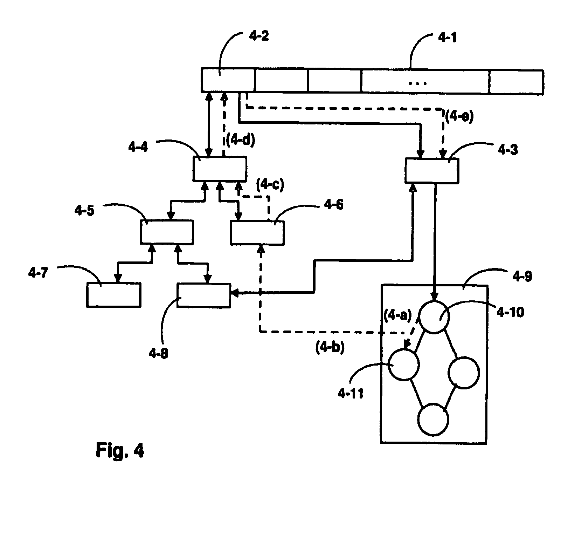

Fig. 4 erläutert die Verfahrensschritte detaillierter, die ablaufen, wenn der aktuell simulierte Prozess einen anderen Prozess aktiviert. Die in der Liste 4-1 abgelegten Verarbeitungseinheiten 4-2 verweisen neben dem Prozessereignis 4-3 auch auf eine hierarchische Struktur von Schedulern. Diese besteht im gezeigten Beispiel aus einem Scheduler 4-4, der einen untergeordneten Scheduler 4-5 und einen Prozess 4-6 verwaltet. Der Scheduler 4-5 verwaltet selbst wieder Prozess 4-7 und Prozess 4-8. Der Simulationskern arbeitet nun den vom Prozessereignis 4-3 referenzierten Knoten 4-10 im Basisblockgraph 4-9 des Prozesses 4-8 ab (Schritt 4-a). Das simuliert ausgeführte Anwendungsprogramm aktiviert in diesem Simulationsschritt den Prozess 4-6. Diese Aktivierung wird nun an Prozess 4-6 weitergegeben (4-b), der wiederum den Scheduler 4-4 darüber informiert (4-c). Scheduler 4-4 prüft nun, ob der bisher aktive Prozess 4-8 bzw. dessen übergeordneter Scheduler 4-5 durch die Aktivierung verdrängt werden muss. Ist dies der Fall, wird die Verarbeitungseinheit 4-2 informiert (4-d), die daraufhin das Prozessereignis 4-3 mit dem neuen Prozess 4-6 aktualisiert (4-e). Entscheidet dagegen Scheduler 4-4, dass keine Prozessverdrängung erfolgen muss, so wird die Verarbeitungseinheit 4-2 nicht informiert und Prozessereignis 4-3 bleibt unverändert, so dass der alte aktive Prozess 4-8 fortgesetzt wird.

Im Simulationsprogramm erfolgt die Simulation der Wechselwirkung zwischen der Software und der Hardware jeder Komponente des realen Systems durch simulierte Zugriffe auf die Register der Hardware so wie es auch im Zielsystem erfolgt. Solche Zugriffe verändern im Zielsystem den internen Zustand der Hardware. Im Simulationsprogramm können derartige Zustandsänderungen einer Hardware durch Aktivieren eines entsprechenden Prozesses simuliert werden. Das weitere funktionale und zeitliche Verhalten der simulierten Hardware kann dann unabhängig vom zeitlichen und funktionalen Verhalten der simulierten Software abgearbeitet werden.

Im Zielsystem erfolgt die Wechselwirkung mehrerer Hardwarekomponenten untereinander durch den Austausch elektrischer Signale. Im Simulationsprogramm werden zur Erhöhung der Simulationsgeschwindigkeit die elektrischen Pegel abstrahiert und in Form komplexer Datenpakete abgebildet.

Obwohl die Erfindung mittels der Figuren und der zugehörigen Beschreibung dargestellt und detailliert beschrieben ist, sind diese Darstellung und diese detaillierte Beschreibung illustrativ und beispielhaft zu verstehen und nicht als die Erfindung einschränkend. Es versteht sich, dass Fachleute Änderungen und Abwandlungen machen können, ohne den Umfang der folgenden Ansprüche zu verlassen. Insbesondere umfasst die Erfindung ebenfalls Ausführungsformen mit jeglicher Kombination von Merkmalen, die vorstehend zu verschiedenen Aspekten und/oder Ausführungsformen genannt oder gezeigt sind.

Die Erfindung umfasst ebenfalls einzelne Merkmale in den Figuren auch wenn sie dort im Zusammenhang mit anderen Merkmalen gezeigt sind und/oder vorstehend nicht genannt sind.

Im Weiteren schließt der Ausdruck "umfassen" und Ableitungen davon andere Elemente oder Schritte nicht aus. Ebenfalls schließt der unbestimmte Artikel "ein" bzw. "eine" und Ableitungen davon eine Vielzahl nicht aus. Die Funktionen mehrerer in den Ansprüchen aufgeführter Merkmale können durch eine Einheit erfüllt sein. Die Begriffe "im Wesentlichen", "etwa", "ungefähr" und dergleichen in Verbindung mit einer Eigenschaft beziehungsweise einem Wert definieren insbesondere auch genau die Eigenschaft beziehungsweise genau den Wert. Alle Bezugszeichen in den Ansprüchen sind nicht als den Umfang der Ansprüche einschränkend zu verstehen.

### Bezugszeichenliste Figur 1

- 1-1: Hostsystem
- 1-2: Projektdatei
- 1-3: Voranalyse
- 1-4: Anwendungsprogramm
- 1-5: Prozessormodellbibliothek
- 1-6: HW-Komponentenbibliothek
- 1-7: Compiler
- 1-8: Objektkode des ersten Simulationsprogrammabschnitts
- 1-9: Binder
- 1-10: Bibliothek des Simulatorkerns
- 1-11: ausführbarer Simulationscode
- 1-12: ablaufende Simulation
- 1-13: Ergebnisbericht
- 1-14: Simulationsspur
- 1-15: Diagramme mit Darstellungen des dynamischen Verhaltens des eingebetteten Systems

### Bezugszeichenliste Figur 2

- 2-1: Verarbeitungseinheitenliste
- 2-2: Verarbeitungseinheit
- 2-3: Eigenschaften der Verarbeitungseinheiten
- 2-4: übergeordneter Scheduler
- 2-5: untergeordneter Scheduler
- 2-6: Prozess
- 2-7: Prozessereignis
- 2-8: Basisblockgraph
- 2-9: Tabelle mit den statischen Ausführungszeiten der Basisblockknoten
- 2-10,2-11: Prozess
- 2-12: Basisblock

### Bezugszeichenliste Figur 3

- 3-1: Simulationskern
- 3-2: Verarbeitungseinheitenliste
- 3-3: Verarbeitungseinheit
- 3-4: Scheduler
- 3-5: Prozessereignis
- 3-6: Basisblockgraph
- 3-7, 3-8: Basisblock
- 3-9: ausgewählte Verarbeitungseinheit
- 3-10: ausgewählter Prozess

- (3-a) ... (3-g): Verfahrensschritte

### Bezugszeichenliste Figur 4

- 4-1: Verarbeitungseinheitenliste
- 4-2: Verarbeitungseinheit
- 4-3: Prozessereignis
- 4-4,4-5: Scheduler
- 4-6,4-7,4-8: Prozess
- 4-9: Basisblockgraph
- 4-10,4-11: Basisblock

- (4-a) ... (4-e): Verfahrensschritte

## Patentansprüche

1. Computergestütztes Verfahren zur Simulation eines eingebetteten Systems, bei dem mehrere, jeweils aus einer mit einer Software versehenen Hardware gebildete Komponenten über ein Datenaustauschnetzwerk miteinander zum Datenaustausch verbunden sind,
wobei in einem Simulationsprogramm jede Komponente als eine eine Menge von Prozessen (2-6; 4-6, 4-7, 4-8) verwaltende Verarbeitungseinheit (2-2; 3-3; 4-2) simuliert wird,
wobei mit dem Simulationsprogramm dynamisch jeder der Verarbeitungseinheiten (2-2; 3-3; 4-2) eine Startzeit zugeordnet wird,
wobei die Verarbeitungseinheiten (2-2; 3-3; 4-2) dynamisch entsprechend ihrer Startzeiten aufeinanderfolgend sortiert werden,
wobei mittels eines Schedulers (2-4, 2-5; 3-4; 4-4, 4-5) jeweils die Verarbeitungseinheit (2-2; 3-3; 4-2) mit der nächsten Startzeit ausgewählt wird,
wobei infolge der Auswahl einer Verarbeitungseinheit (2-2; 3-3; 4-2) der ihr zugeordnete aktive Prozess durch Abarbeitung eines aus einem dazu korrespondierenden Basisblockgraphen (2-8; 3-6; 4-9) abgeleiteten Programmcode simuliert und als Ergebnis der Simulation die für die Abarbeitung benötigte Zeit und/oder eine Information über die damit bewirkte Funktion ermittelt wird,
wobei nach der Abarbeitung jedes zu einem Basisblock (2-12; 3-7, 3-8; 4-10. 4-11) korrespondierenden Programmcodeabschnitts in Abhängigkeit vorgegebener Parameter geprüft wird, ob mittels des Schedulers (2-4; 2-5; 3-4: 4-4, 4-5) die nächste Verarbeitungseinheit (2-2; 3-3; 4-2) auszuwählen ist und/oder ob der aktive Prozess auf der ausgewählten Verarbeitungseinheit (2-2; 3-3; 4-2) fortzusetzen ist.

2. Verfahren nach Anspruch 1, wobei jeder Verarbeitungseinheit (2-2; 3-3; 4-2) ein Uhrensimulationsprogramm zugeordnet ist und die für die Abarbeitung eines Prozesses benötigte lokale Zeit unter Verwendung des Uhrensimulationsprogramms ermittelt wird.

3. Verfahren nach einem der vorhergehenden Ansprüche, wobei die lokalen Zeiten unter Verwendung der Systemzeit in die Startzeiten umgerechnet werden.

4. Verfahren nach einem der vorhergehenden Ansprüche, wobei jeder Prozess (2-6; 4-6, 4-7, 4-8) durch zumindest einen Basisblock (2-12; 3-7, 3-8; 4-10, 4-11) im Basisblockgraphen (2-8; 3-6; 4-9) beschrieben wird.

5. Verfahren nach einem der vorhergehenden Ansprüche, wobei der Basisblock (2-12; 3-7, 3-8; 4-10, 4-11) mit einer Information versehen wird, die es ermöglicht, die für die Abarbeitung des Basisblocks (2-12; 3-7, 3-8; 4-10, 4-11) erforderliche Ausführungszeit und/oder die durch die Abarbeitung des Basisblocks (2-12; 3-7, 3-8; 4-10, 4-11) erzeugte Funktion zu ermitteln.

6. Verfahren nach einem der vorhergehenden Ansprüche, wobei der die Basisblöcke (2-12; 3-7, 3-8; 4-10, 4-11) enthaltende Basisblockgraph (2-8; 3-6; 4-9) mittels eines Compilers in den Programmcode übersetzt wird.

7. Verfahren nach einem der vorhergehenden Ansprüche, wobei das simulierte eingebettete System einen oder mehrere hierarchische Scheduler (2-4; 2-5; 3-4; 4-4, 4-5) verwendet.

8. Verfahren nach einem der vorhergehenden Ansprüche, wobei das Simulationsprogramm einen die Verarbeitungseinheiten (2-2; 3-3; 4-2) umfassenden ersten Simulationsprogrammabschnitt und einen die Ausführungszeiten und/oder die Funktion ermittelnden zweiten Simulationsprogrammabschnitt aufweist.

9. Verfahren nach einem der vorhergehenden Ansprüche, wobei das Simulationsprogramm auf einem Hostcomputer durchgeführt wird, dessen Prozessor identisch oder ähnlich mit einem weiteren Prozessor des eingebetteten Systems ist.

10. Computerprogramm, das Computerprogrammcodemittel umfasst, die für die Ausführung aller Schritte aus einem der Ansprüche 1 bis 9 geeignet sind, wenn das Programm auf einem Computer ausgeführt wird.

11. Computerprogrammprodukt mit Programmcodemitteln, die auf einem computerlesbaren Datenträger gespeichert sind, um das Verfahren nach einem der Ansprüche 1 bis 9 durchzuführen, wenn das Programmprodukt auf einem Computer ausgeführt wird.

12. Datenverarbeitungssystem zur Simulation eines eingebetteten Systems, bei dem mehrere, jeweils aus einer mit einer Software versehenen Hardware gebildete Komponenten über ein Datenaustauschnetzwerk miteinander zum Datenaustausch verbunden sind, mit
einem Simulationsprogramm, in dem jede Komponente als eine eine Menge von Prozessen (2-6; 4-6, 4-7, 4-8) verwaltende Verarbeitungseinheit (2-2; 3-3; 4-2) simuliert wird,
wobei mit dem Simulationsprogramm dynamisch jeder der Verarbeitungseinheiten (2-2; 3-3; 4-2) eine Startzeit zugeordnet wird,
einer Sortiereinrichtung, die die Verarbeitungseinheiten (2-2; 3-3; 4-2) dynamisch entsprechend ihrer Startzeiten aufeinanderfolgend sortiert,
einem Scheduler (2-4, 2-5; 3-4; 4-4, 4-5) zum Auswählen der Verarbeitungseinheit (2-2; 3-3; 4-2) mit der nächsten Startzeit,
wobei das Datenverarbeitungssystem infolge der Auswahl einer Verarbeitungseinheit (2-2; 3-3; 4-2) den ihr zugeordneten aktive Prozess durch Abarbeitung eines aus einem dazu korrespondierenden Basisblockgraphen (2-8; 3-6; 4-9) abgeleiteten Programmcode simuliert und als Ergebnis der Simulation die für die Abarbeitung benötigte Zeit und/oder eine Information über die damit bewirkte Funktion ermittelt wird,
wobei das Datenverarbeitungssystem eingerichtet ist, nach der Abarbeitung jedes zu einem Basisblock (2-12; 3-7, 3-8; 4-10, 4-11) korrespondierenden Programmcodeabschnitts in Abhängigkeit vorgegebener Parameter zu prüfen, ob mittels des Schedulers die nächste Verarbeitungseinheit (2-2; 3-3; 4-2) auszuwählen ist und/oder ob der aktive Prozess auf der ausgewählten Verarbeitungseinheit (2-2; 3-3; 4-2) fortzusetzen ist.

13. Datenverarbeitungssystem nach Anspruch 12, wobei jeder Verarbeitungseinheit (2-2; 3-3; 4-2) ein Uhrensimulationsprogramm zugeordnet ist und die für die Abarbeitung eines Prozesses benötigte lokale Zeit unter Verwendung des Uhrensimulationsprogramms ermittelt wird.

14. Datenverarbeitungssystem nach Anspruch 12 oder 13, wobei das Datenverarbeitungssystem eingerichtet ist, die lokalen Zeiten unter Verwendung der Systemzeit in die Startzeiten umzurechnen.

15. Datenverarbeitungssystem nach Anspruch 12, 13 oder 14, wobei jeder Prozess (2-6; 4-6, 4-7, 4-8) durch zumindest einen Basisblock (2-12; 3-7, 3-8; 4-10, 4-11) im Basisblockgraphen (2-8; 3-6; 4-9) beschrieben wird.

16. Datenverarbeitungssystem nach einem der Ansprüche 12 bis 15, wobei der Basisblock (2-12; 3-7, 3-8; 4-10, 4-11) mit einer Information versehen ist, die es ermöglicht, die für die Abarbeitung des Basisblocks (2-12; 3-7, 3-8; 4-10, 4-11) erforderliche Ausführungszeit und/oder die durch die Abarbeitung des Basisblocks (2-12; 3-7, 3-8; 4-10, 4-11) erzeugte Funktion zu ermitteln.

17. Datenverarbeitungssystem nach einem der Ansprüche 12 bis 16, wobei das Datenverarbeitungssystem eingerichtet ist, den die Basisblöcke (2-12; 3-7, 3-8; 4-10, 4-11) enthaltende Basisblockgraphen (2-8; 3-6; 4-9) mittels eines Compilers in den Programmcode zu übersetzen.

18. Datenverarbeitungssystem nach einem der Ansprüche 12 bis 17, wobei das simulierte eingebettete System einen oder mehrere hierarchische Scheduler (2-4, 2-5; 3-4; 4-4, 4-5) verwendet.

19. Datenverarbeitungssystem nach einem der Ansprüche 12 bis 18, wobei das Simulationsprogramm einen die Verarbeitungseinheiten (2-2; 3-3; 4-2) umfassenden ersten Simulationsprogrammabschnitt und einen die Ausführungszeiten und/oder die Funktion ermittelnden zweiten Simulationsprogrammabschnitt aufweist.

20. Datenverarbeitungssystem nach einem der Ansprüche 12 bis 19, wobei das Simulationsprogramm auf einem Hostcomputer durchgeführt wird, dessen Prozessor identisch oder ähnlich mit einem weiteren Prozessor des eingebetteten Systems ist.

## Claims

1. Computer-assisted method for simulating an embedded system, wherein a plurality of hardware components, each provided with software, are connected via a data exchange network for data exchange,
wherein in a simulation program every component is simulated as a processing unit (2-2; 3-3; 4-2) managing an amount of processes (2-6; 4-6, 4-7, 4-8),
wherein with the simulation program, a start time is dynamically assigned to every processing unit (2-2; 3-3; 4-2),
wherein the processing units (2-2; 3-3; 4-2) are successively sorted dynamically according to their start times,
wherein the processing unit (2-2; 3-3; 4-2) with the next start time is respectively selected via a scheduler (2-4, 2-5; 3-4; 4-4, 4-5),
wherein, due to the selection of a processing unit (2-2; 3-3; 4-2), the respective active process is simulated by execution of a program code derived from a corresponding basic block graph (2-8; 3-6; 4-9) and as a result of the simulation, the time required for the execution and/or information about the effected function is/are determined,
wherein following the execution of each program code section corresponding to a basic block (2-12; 3-7, 3-8; 4-10, 4-11), it is examined according to given parameters whether the next processing unit (2-2; 3-3; 4-2) is to be selected by means of the scheduler (2-4, 2-5; 3-4; 4-4, 4-5) and/or whether the active process is to be continued on the selected processing unit (2-2; 3-3; 4-2).

2. The method according to claim 1, wherein every processing unit (2-2; 3-3; 4-2) is assigned a clock simulation program and the local time required for the execution of a process is determined using the clock simulation program.

3. The method according to any one of the preceding claims, wherein the local times are translated to the start times by using the system time.

4. The method according to any one of the preceding claims, wherein every process (2-6; 4-6, 4-7, 4-8) is described by at least one basic block (2-12; 3-7, 3-8; 4-10, 4-11) in the basic block graph (2-8; 3-6; 4-9).

5. The method according to any one of the preceding claims, wherein the basic block (2-12; 3-7, 3-8; 4-10, 4-11) is provided with information enabling the determination of the execution time necessary for the execution of the basic block (2-12; 3-7, 3-8; 4-10, 4-11) and/or the function generated by the execution of the basic block (2-12; 3-7, 3-8; 4-10, 4-11).

6. The method according to any one of the preceding claims, wherein the basic block graph (2-8; 3-6; 4-9) containing the basic blocks (2-12; 3-7, 3-8; 4-10, 4-11) is translated by means of a compiler into the program code.

7. The method according to any one of the preceding claims, wherein the simulated embedded system uses one or more hierarchical schedulers (2-4, 2-5; 3-4; 4-4, 4-5).

8. The method according to any one of the preceding claims, wherein the simulation program has a first simulation program section comprising the processing units (2-2; 3-3; 4-2) and a second simulation program section determining the execution times and/or the function.

9. The method according to any one of the preceding claims, wherein the simulation program is executed on a host computer whose processor is identical or similar to a further processor of the embedded system.

10. Computer program comprising computer program code means suitable for the execution of all steps according to any one of claims 1 to 9, when the program is executed on a computer.

11. Computer program product with program code means stored on a computer-readable data carrier to carry out the method according to any one of claims 1 to 9 when the program product is executed on a computer.

12. Data processing system for simulating an embedded system, wherein a plurality of hardware components, respectively provided with a software, are connected via a data exchange network for data exchange, comprising
a simulation program, wherein every component is simulated as a processing unit (2-2; 3-3; 4-2) managing an amount of processes (2-6; 4-6, 4-7, 4-8),
wherein with the simulation program, a start time is dynamically assigned to every processing unit (2-2; 3-3; 4-2),
a sorting means sorting the processing units (2-2; 3-3; 4-2) dynamically according to their start times,
a scheduler (2-4, 2-5; 3-4; 4-4, 4-5) for selecting the processing unit (2-2; 3-3; 4-2) with the next start time,
wherein the data processing system simulates, due to the selection of a processing unit (2-2; 3-3; 4-2), the active process assigned to it by executing a program code derived from a corresponding basic block graph (2-8; 3-6; 4-9) and as a result of the simulation, the time required for execution and/or information about the effected function is determined, wherein the data processing system is adapted to examine, following the execution of each program code section corresponding to a basic block (2-12; 3-7, 3-8; 4-10, 4-11), according to given parameters whether the next processing unit (2-2; 3-3; 4-2) is to be selected by means of the scheduler and/or whether the active process is to be continued on the selected processing unit (2-2; 3-3; 4-2).

13. The data processing system according to claim 12, wherein every processing unit (2-2; 3-3; 4-2) is assigned a clock simulation program and the local time required for the execution of a process is determined using the clock simulation program.

14. The data processing system according to claim 12 or 13, wherein the data processing system is adapted to translate the local times into the start times using the system time.

15. The data processing system according to claim 12, 13 or 14, wherein every process (2-6; 4-6, 4-7, 4-8) is described by at least one basic block (2-12; 3-7, 3-8; 4-10, 4-11) in the basic block graph (2-8; 3-6; 4-9).

16. The data processing system according to any one of claims 12 to 15, wherein the basic block (2-12; 3-7, 3-8; 4-10, 4-11) is provided with information enabling the determination of the execution time necessary for the execution of the basic block (2-12; 3-7, 3-8; 4-10, 4-11) and/or the function generated by the execution of the basic block (2-12; 3-7, 3-8; 4-10, 4-11).

17. The data processing system according to any of claims 12 to 16, wherein the data processing system is adapted to translate the basic block graphs (2-8; 3-6; 4-9) containing the basic blocks (2-12; 3-7, 3-8; 4-10, 4-11) into the program code by means of a compiler.

18. The data processing system according to any one of claims 12 to 17, wherein the simulated embedded system uses one or more hierarchical schedulers (2-4, 2-5; 3-4; 4-4, 4-5).

19. The data processing system according to any one of claims 12 to 18, wherein the simulation program has a first simulation program section comprising the processing units (2-2; 3-3; 4-2) and a second simulation program section determining the execution times and/or the function.

20. The data processing system according to any one of claims 12 to 19, wherein the simulation program is carried out on a host computer whose processor is identical or similar to a further processor of the embedded system.

## Revendications

1. Procédé assisté par ordinateur pour la simulation d'un système intégré, où plusieurs composants formés chacun d'un matériel doté d'un logiciel sont reliés entre eux par un réseau de communication de données pour permettre un échange de données,
où, dans un programme de simulation, chaque composant est simulé comme une unité de traitement (2-2 ; 3-3 ; 4-2) administrant une quantité de processus (2-6 ; 4-6, 4-7, 4-8), où un temps de démarrage est dynamiquement affecté à chaque unité de traitement (2-2 ; 3-3 ; 4-2) avec le programme de simulation,
où les unités de traitement (2-2 ; 3-3 ; 4-2) sont dynamiquement triées successivement en fonction de leur temps de démarrage,
où chaque unité de traitement (2-2 ; 3-3 ; 4-2) avec le temps de démarrage suivant est sélectionnée au moyen d'un ordonnanceur (2-4, 2-5 ; 3-4 ; 4-4, 4-5),
où, suite à la sélection d'une unité de traitement (2-2 ; 3-3 ; 4-2), le processus actif qui lui est affecté est simulé par exécution d'un code programme dérivé d'un schéma fonctionnel de base (2-8 ; 3-6 ; 4-9) correspondant, et où le temps exigé pour l'exécution et/ou une information sur la fonction ainsi activée sont déterminés comme résultat de la simulation,
où après l'exécution de chaque section de code programme correspondant à un bloc de base (2-12 ; 3-7, 3-8 ; 4-10, 4-11), il est contrôlé en fonction de paramètres définis si l'unité de traitement (2-2 ; 3-3 ; 4-2) suivante doit être sélectionnée au moyen de l'ordonnanceur (2-4 ; 2-5 ; 3-4 ; 4-4, 4-5), et/ou si le processus actif doit être poursuivi sur l'unité de traitement (2-2 ; 3-3 ; 4-2) sélectionnée.

2. Procédé selon la revendication 1, où un programme d'horloge de simulation est affecté à chaque unité de traitement (2-2 ; 3-3 ; 4-2), et où le temps local exigé pour l'exécution d'un processus est déterminé en exploitant le programme d'horloge de simulation.

3. Procédé selon l'une des revendications précédentes, où les temps locaux sont convertis comme temps de démarrage en exploitant le temps système.

4. Procédé selon l'une des revendications précédentes, où chaque processus (2-6 ; 4-6, 4-7, 4-8) est décrit par au moins un bloc de base (2-12 ; 3-7, 3-8 ; 4-10, 4-11) dans le schéma fonctionnel de base (2-8 ; 3-6 ; 4-9).

5. Procédé selon l'une des revendications précédentes, où le bloc de base (2-12 ; 3-7, 3-8 ; 4-10, 4-11) est pourvu d'une information qui permet de déterminer le temps d'exécution exigé pour l'exécution du bloc de base (2-12 ; 3-7, 3-8 ; 4-10, 4-11) et/ou la fonction générée par l'exécution du bloc de base (2-12 ; 3-7, 3-8 ; 4-10, 4-11).

6. Procédé selon l'une des revendications précédentes, où schéma fonctionnel de base (2-8 ; 3-6 ; 4-9) contenant les blocs de base (2-12 ; 3-7, 3-8 ; 4-10, 4-11) est traduit en code programme au moyen d'un compilateur.

7. Procédé selon l'une des revendications précédentes, où le système intégré simulé utilise un ou plusieurs ordonnanceurs hiérarchiques (2-4 ; 2-5 ; 3-4 ; 4-4, 4-5).

8. Procédé selon l'une des revendications précédentes, où le programme de simulation comporte une première section de programme de simulation comprenant les unités de traitement (2-2 ; 3-3 ; 4-2), et une deuxième section de programme de simulation déterminant les temps d'exécution et/ou la fonction.

9. Procédé selon l'une des revendications précédentes, où le programme de simulation est exécuté sur un ordinateur hôte, dont le processeur est identique ou similaire à un autre processeur du système intégré.

10. Programme informatique, déterminant des moyens de code programme informatique appropriés pour l'exécution de toutes les étapes selon l'une des revendications 1 à 9 quand le programme est exécuté sur un ordinateur.

11. Produit de programme informatique avec des moyens de code programme mémorisés sur un support de données lisible par un ordinateur, pour exécuter le procédé selon l'une des revendications 1 à 9 quand le produit de programme est exécuté sur un ordinateur.

12. Système de traitement de données pour la simulation d'un système intégré, où plusieurs composants formés chacun d'un matériel doté d'un logiciel sont reliés entre eux par un réseau de communication de données pour permettre un échange de données, avec
un programme de simulation, où chaque composant est simulé comme une unité de traitement (2-2 ; 3-3 ; 4-2) administrant une quantité de processus (2-6 ; 4-6, 4-7, 4-8),
un temps de démarrage étant dynamiquement affecté à chaque unité de traitement (2-2 ; 3-3 ; 4-2) avec le programme de simulation,
un dispositif de tri, qui trie dynamiquement les unités de traitement (2-2 ; 3-3 ; 4-2) successivement en fonction de leur temps de démarrage,
un ordonnanceur (2-4, 2-5 ; 3-4 ; 4-4, 4-5) pour sélectionner l'unité de traitement (2-2 ; 3-3 ; 4-2) avec le temps de démarrage suivant,
où, suite à la sélection d'une unité de traitement (2-2 ; 3-3 ; 4-2), le système de traitement de données simule le processus actif qui lui est affecté par exécution d'un code programme dérivé d'un schéma fonctionnel de base (2-8 ; 3-6 ; 4-9) correspondant, et où le temps exigé pour l'exécution et/ou une information sur la fonction ainsi activée sont déterminés comme résultat de la simulation,
ledit système de traitement de données étant prévu pour qu'après l'exécution de chaque section de code programme correspondant à un bloc de base (2-12 ; 3-7, 3-8 ; 4-10, 4-11), il soit contrôlé en fonction de paramètres définis si l'unité de traitement (2-2 ; 3-3 ; 4-2) suivante doit être sélectionnée au moyen de l'ordonnanceur, et/ou si le processus actif doit être poursuivi sur l'unité de traitement (2-2 ; 3-3 ; 4-2) sélectionnée.

13. Système de traitement de données selon la revendication 12, où un programme d'horloge de simulation est affecté à chaque unité de traitement (2-2 ; 3-3 ; 4-2), et où le temps local exigé pour l'exécution d'un processus est déterminé en exploitant le programme d'horloge de simulation.

14. Système de traitement de données selon la revendication 12 ou 13, ledit système de traitement de données étant prévu pour convertir les temps locaux en temps de démarrage en exploitant le temps système.

15. Système de traitement de données selon la revendication 12, 13 ou la revendication 14, où chaque processus (2-6 ; 4-6, 4-7, 4-8) est décrit par au moins un bloc de base (2-12 ; 3-7, 3-8 ; 4-10, 4-11) dans le schéma fonctionnel de base (2-8 ; 3-6 ; 4-9).

16. Système de traitement de données selon l'une des revendications 12 à 15, où le bloc de base (2-12 ; 3-7, 3-8 ; 4-10, 4-11) est pourvu d'une information qui permet de déterminer le temps d'exécution exigé pour l'exécution du bloc de base (2-12 ; 3-7, 3-8 ; 4-10, 4-11) et/ou la fonction générée par l'exécution du bloc de base (2-12 ; 3-7, 3-8 ; 4-10, 4-11).

17. Système de traitement de données selon l'une des revendications 12 à 16, ledit système de traitement de données étant prévu pour traduire en code programme les schémas fonctionnels de base (2-8 ; 3-6 ; 4-9) contenant les blocs de base (2-12 ; 3-7, 3-8 ; 4-10, 4-11) au moyen d'un compilateur.

18. Système de traitement de données selon l'une des revendications 12 à 17, où le système intégré simulé utilise un ou plusieurs ordonnanceurs hiérarchiques (2-4 , 2-5 ; 3-4 ; 4-4, 4-5).

19. Système de traitement de données selon l'une des revendications 12 à 18, où le programme de simulation comporte une première section de programme de simulation comprenant les unités de traitement (2-2 ; 3-3 ; 4-2), et une deuxième section de programme de simulation déterminant les temps d'exécution et/ou la fonction.

20. Système de traitement de données selon l'une des revendications 12 à 19, où le programme de simulation est exécuté sur un ordinateur hôte, dont le processeur est identique ou similaire à un autre processeur du système intégré.
